# EUROPÄISCHE PATENTSCHRIFT

(11) **EP 0 491 262 B1**
(45) Veröffentlichungstag und Bekanntmachung des Hinweises auf die Patenterteilung: **05.11.1997**
(21) Anmeldenummer: 91121132.4
(22) Anmeldetag: 10.12.1991
(51) Int. Cl.: H01L 25/07

(54) **Halbleitermodul**
Semiconductor module
Module semi-conducteur

(30) Priorität: 18.12.1990 DE 9017041 U
(43) Veröffentlichungstag der Anmeldung: 24.06.1992
(73) Patentinhaber: Akyürek, Altan, 91207 Lauf (DE); Maier, Peter H., 91207 Lauf (DE); Schulz-Harder, Jürgen, Dr.-Ing., 91207 Lauf (DE)
(72) Erfinder: Akyürek, Altan, 91207 Lauf (DE); Maier, Peter H., 91207 Lauf (DE); Schulz-Harder, Jürgen, Dr.-Ing., 91207 Lauf (DE)
(74) Vertreter: Patentanwälte Möll und Bitterich

(56) Entgegenhaltungen:
- EP-A- 0 152 818
- EP-A- 0 312 631
- DE-A- 2 939 732
- DE-A- 3 442 803
- DE-U- 9 017 041
- US-A- 4 500 029
- Electronics Engineering, vol. 60; no. 743, Nov. 1988, pages 13-14.

## Beschreibung

Die Erfindung betrifft ein Halbleiter-Modul gemäß Anspruch 1.

Ein derartiges Leistungs-Halbleitermodul mit integrierter Ansteuerungs- und Fehlerschutzplatine ist Gegenstand der älteren, nicht vorveröffentlichten europäischen Patentanmeldung 0 463 589. In einem isolierenden Gehäuse sind ein Bodensubstrat und wenigstens eine Ansteuerungsplatine so untergebracht, daß sie etwa rechtwinklig zueinander orientiert sind. Das Bodensubstrat ist eine Keramikplatte mit Kontaktflächen und Leiterbahnen aus Kupferblech, angebracht im Direct-Bonding-Verfahren. Die Ansteuerplatine ist ein Keramikhybrid, eine Kunststoffplatine oder eine Mehrschicht-Substrat. Sie besitzt an einer Längsseite eine Anzahl von Kontaktbeinen, die nach der Montage im Gehäuse mit entsprechenden Kontaktflächen auf dem Bodensubstrat verlötet werden. Die Halbleiterchips sind teils durch Verlöten, teils durch Drahtbonden mit den Kontaktflächen des Bodensubstrats kontaktiert.

Ein weiteres Halbleiter-Modul offenbart die UK-Zeitschrift "Electronic Engineering", November 1988, Seiten 13 und 14. Auch dieses Modul verwendet als Bodensubstrat eine Keramikplatte mit Leiterbahnen und elektronischen Bauelementen. Das Bodensubstrat ist entlang der beiden Längsseiten mehrfach durchbohrt. Zwei Seitenplatinen tragen entlang je einer Längskante eine Anzahl von Anschlußdrähten. Diese Drähte sind durch die Bohrungen des Bodensubstrates gesteckt und mit den entsprechenden Kontaktflächen verlötet. Sie bilden gleichzeitig die Dual-Inline-Anschlüsse des kompletten Moduls.

Eine Methode zum Herstellen von überkreuzungen bei Kupferleiterbahnen, die mit Hilfe des Direct-Bonding-Verfahrens mit einem keramischen Substrat verbunden sind, ist bekannt aus der US-Patentschrift 4 500 029. Bei dieser Methode werden Teile der Kupfer-Bleche durch geeignete Beschichtungen daran gehindert, sich mit dem Keramiksubstrat und/oder anderen Kupferblechen zu verbinden. Diese Methode ist in der Praxis äußerst schwierig. Die überkreuzungen sind mechanisch instabil, weil das Kupfer infolge der Wärmebehandlung weich wird. In vielen Fällen besitzen die fertigen überkreuzungen nicht die gewünschte isolierende Wirkung.

Der vorliegenden Erfindung liegt die Aufgabe zugrunde, ein Halbleiter-Modul der eingangs genannten Art anzugeben, das in einer zweiten, dritten usw. Ebene verlaufende Leiterbahnen besitzt, die jedoch gleichzeitig mit den Leiterbahnen der ersten Ebene in ein und demselben Arbeitsgang hergestellt werden können.

Diese Aufgabe wird gelöst durch ein Halbleiter-Modul mit den Merkmalen des Anspruchs 1.

Die vorliegende Erfindung geht somit aus von einer Abwicklung des Leiterbahnenbildes des fertigen Moduls auf die Ebene der Grundfläche. Dadurch ist es möglich, wie bisher Kontaktbleche, Leiterbahnenbleche und Basisblech in einem Arbeitsgang fertigzustellen und im Direct-Bonding-Verfahren in einem einzigen Ofendurchlauf mit der Keramik zu verbinden. Man kann die Keramik-Platten in einer entsprechenden Halterung nebeneinander legen und mit den vorbereiteten Blechen belegen. Bevorzugt wird man jedoch von einer einheitlichen, einstückigen Grundplatte aus Keramik ausgehen, die nach dem Fertigstellen der Kontaktflächen und Leiterbahnen von der Rückseite her geritzt und gebrochen wird, um so die gewünschten Teilplatten zu erzeugen.

Die über die Metallbleche miteinander verbundenen Keramikplatten werden dann zu einem dreidimensionalen Gebilde gefaltet, wodurch die Leiterbahnen wie gewünscht in die zweite, dritte usw. Ebene gelangen.

Um die geforderte Spannungsfestigkeit sicherstellen zu können, ist für einen ausreichenden Abstand zwischen benachbarten Keramikplatten bzw. deren elektrisch leitenden Bereichen zu sorgen. Dies wird dadurch sichergestellt, daß im Grenzbereich zwischen zwei Platten das Leiterbahnenblech ohne Verbindung zur Keramik bleibt. Hierzu kann entweder eine Trennmaske zwischen Platte und Leiterbahnenblech vorgesehen sein, oder das Leiterbahnenblech wird brückenartig vorgeformt.

Vorzugsweise läßt sich das Ende des Leiterbahnenblechs direkt mit einem Anschlußpol der Halbleiterchips, beispielsweise mit der Steuerelektrode eines Thyristors oder Transistors, verbinden, da durch die schon erwähnten Maßnahmen das Ende des Leiterbahnenblechs ohne Verbindung zur Keramik bleibt.

Schließlich besitzen die Seitenplatten auch ausreichend Fläche, um eine komplette Elektronikeinheit aufzunehmen, beispielsweise eine Ansteuerelektronik für die Leistungshalbleiterchips. Aufgrund der Trennung der Seitenplatten von der thermisch hoch belasteten Grundplatte wird auch nur relativ wenig Wärme auf die Seitenplatten übertragen, so daß diese meist ohne besondere Kühlung bleiben können.

Anhand der Zeichnung soll die Erfindung in Form von Ausführungsbeispielen näher erläutert werden. Es zeigen
- Fig. 1: eine perspektivische Darstellung einer ersten Ausführungsform eines Halbleiter-Moduls,
- Fig. 2: eine perspektivische Darstellung einer zweiten Ausführungsform eines Halbleiter-Moduls und
- Fig. 3: eine Frontsicht einer dritten Ausführungsform einer Ausgangsplatte zur Herstellung eines Halbleitermoduls.

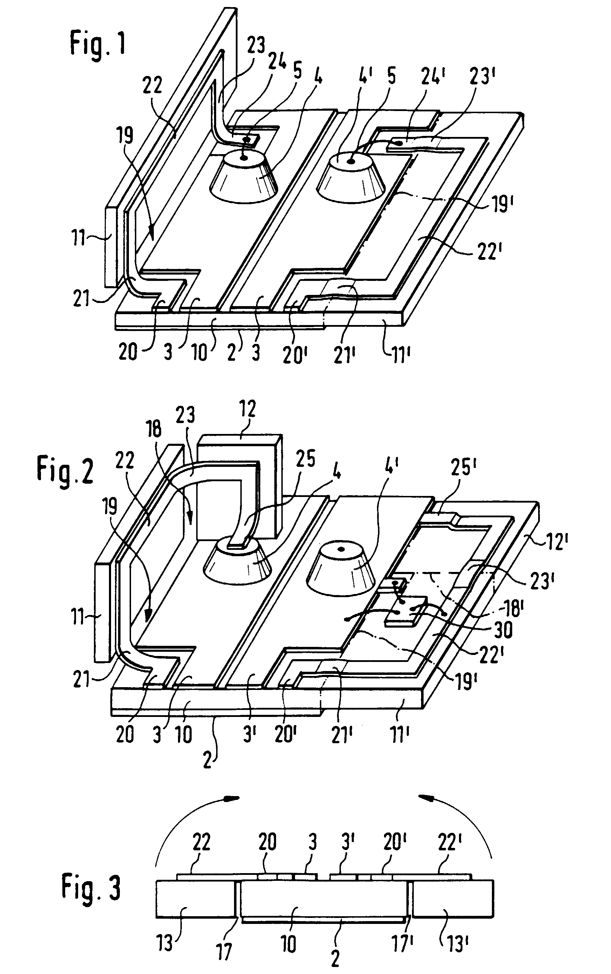

Fig. 1 zeigt eine Keramikplatte 10, die auf ihrer Unterseite eine Basisblechplatte 2, auf ihrer Oberseite zwei Kontaktbleche 3, 3' trägt. Auf den Kontaktblechen 3, 3' ist je ein Halbleiterchip 4, 4' aufgelötet.

Entlang einer (strichpunktierten) Trennlinie 19' wird die Keramikgrundplatte 10 nach dem Fertigstellen aller Leiterbahnen und Kontaktflächen geritzt und gebrochen, so daß von der Keramikgrundplatte 10 getrennte Seitenplatten 11, 11' entstehen, die beispielsweise senkrecht hochgebogen werden, wie die im linken Bildteil dargestellte Seitenplatte 11. Leiterbahnen 20, 20' verbinden die Keramikgrundplatte 10 und die Seitenteile 11, 11'. Durch das Hochklappen der Seitenteile 11, 11' gelangen die Leiterbahnen 22, 22' wie gewünscht in die zweite Ebene und es entsteht ein äußerst platzsparender Aufbau mit Überkreuzungen.

Um die in der Praxis geforderte Spannungsfestigkeit garantieren zu können, muß zwischen Keramikgrundplatte 10 und Seitenplatten 11, 11' bzw. zwischen deren elektrisch leitfähigen Teilen ein ausreichend bemessener Abstand 19 eingehalten werden. Dies ist jedoch nur möglich, wenn die Leiterbahnenbleche 20, 20' im Grenzbereich zwischen zwei Platten 10, 11, 11' nicht mit der Keramik verbunden sind. Dies erreicht man beispielsweise durch eine brückenartige Vorformung 21', 23' der Leiterbahnenbleche 20, 20'.

Alternativ dazu kann auch eine Trennmaske zwischen Keramik 10, 11, 11' und Leiterbahnenbereich 21', 23' vorgesehen werden.

Fig. 2 zeigt eine Ausführungsform, bei der neben der Grundplatte 10 jeweils zwei Seitenteile 11, 11', 12, 12' vorgesehen sind. Die Herstellung erfolgt wieder ausgehend von einer einstückigen Keramikplatte, wobei alle Bleche 2, 3, 3', 20, 20' in der Grundebene liegend in einem Ofendurchlauf mit der Keramik verbunden werden. Anschließend wird die Keramik von der Rückseite her entlang den Trennlinien 18', 19' geritzt, gebrochen und wie in der Zeichnung dargestellt gefaltet. Die freien Enden 25, 25' der Leiterbahnenbleche 20, 20' können gebogen und direkt auf die Anschlußkontakte der Halbleiterchips 4, 4' gelötet werden.

Wie die Fig. 1 und 2 erkennen lassen, bieten die Seitenplatten 11, 11', 12, 12' ausreichend Platz, um mehrere Leiterbahnenbleche aufzunehmen. Aufgrund der Trennung der Seitenplatten von der Grundplatte wird auch nur wenig Wärme auf die Seitenplatten übertragen. Diese können somit komplette Elektronikeinheiten aufnehmen, beispielsweise zur Bildung von Ansteuersignalen für die Leistungshalbleiterchips 4, 4'.

Fig. 3 schließlich zeigt in schematischer Darstellung, daß Grundplatte 10 und Seitenplatten 13, 13' schon von Anfang an getrennt sein können, wodurch ausreichend bemessene Lücken 17, 17' eingehalten werden können. Allerdings muß durch geeignete Halterungen dafür gesorgt werden, daß die Keramikplatten 10, 13, 13' ihre gegenseitige Position während des Bondens der Kupferbleche 2, 3, 3', 20, 20' beibehalten.

Unabhängig davon, ob man von einer einstückigen Keramikplatte oder von mehreren Keramikplatten ausgeht, bietet die Erfindung die Möglichkeit, sämtliche Leiterbahnen und Kontaktflächen in einer Ebene liegend und in einem Arbeitsgang mit der Keramik zu verbinden und anschließend durch einfaches oder mehrfaches Falten der Seitenplatten ein kompaktes Modul mit Leiterbahnen und Kontakflächen in mehreren Ebenen übereinander zu erzeugen, ohne daß zusätzliche Anschlußclipse, Brücken, Drähte und/oder Isolierteile von Hand montiert oder gelötet werden müssen.

## Patentansprüche

1. Halbleiter-Modul, bestehend aus einer mit einer Ober- und einer Rückseite versehenen Grundplatte (10) und wenigstens einer etwa im rechten Winkel zur Grundplatte (10) stehenden Seitenplatte (11, 11', 12, 12'), beide Platten aus Keramik, wobei ein der geforderten Spannungsfestigkeit entsprechender Spalt (18, 19) eingehalten ist, sowie wenigstens einem Kontaktblech (3, 3'), wenigstens einem Leiterbahnenblech (20, 20') und gegebenenfalls einem Basisblech (2), das Kontaktblech und das Leiterbahnenblech mittles eines Metall-Gas-Eutektikums mit der Oberseite der Grundplatte (10) und wenigstens mit einer der Seitenplatten (11, 11', 12, 12', 13, 13') verbunden, das Basisblech mittels eines Metall-Gas-Eutektikums mit der Rückseite der Grundplatte verbunden, wobei auf dem Kontaktblech (3, 3') Halbleiterchips (4, 4') befestigt sind, wenigstens ein Leiterbahnenblech (20, 20') einstückig von der Grundplatte (10) auf die Seitenplatte (11 ... 13') geführt ist und im Grenzbereich zwischen zwei Platten (10 ... 13') das Leiterbahnenblech (20, 20') ohne Verbindung zur Keramik ist.

2. Halbleiter-Modul nach Anspruch 1, dadurch gekennzeichnet, daß ein Ende (25, 25') des Leiterbahnenblechs (20, 20') ohne Verbindung zur Keramik ist.

3. Halbleiter-Modul nach Anspruch 1 oder 2, dadurch gekennzeichnet, daß ein Ende (25) des Leiterbahnenblechs (20) einen Anschlußpol eines Halbleiterchips (4) direkt kontaktiert.

4. Halbleiter-Modul nach Anspruch 1, 2 oder 3, dadurch gekennzeichnet, daß im Grenzbereich zwischen zwei Platten eine Trennmaske zwischen Platte (10 ... 13') und Leiterbahnenblech (20, 20') vorgesehen ist.

5. Halbleiter-Modul nach einem der Ansprüche 1 bis 4, dadurch gekennzeichnet, daß im Grenzbereich zwischen zwei Platten das Leiterbahnenblech (21', 23', 25') brückenartig vorgeformt ist.

6. Halbleiter-Modul nach einem der Ansprüche 1 bis 5, dadurch gekennzeichnet, daß eine Seitenplatte (11 ... 13') eine Ansteuerelektronik (30) trägt.

7. Halbleiter-Modul nach einem der Ansprüche 1 bis 6, dadurch gekennzeichnet, daß die Bleche (1, 3, 3', 20, 20') aus Kupfer, gegebenenfalls mit Kupfer-I-Oxid, die Platten (10 ... 13') aus Al₂O₃ oder BeO bestehen.

8. Halbleiter-Modul nach einem der Ansprüche 1 bis 7, dadurch gekennzeichnet, daß die Grundplatte (10) und die Seitenplatte/n (11, ... 12') aus einer einstückig verarbeiteten, in einem Arbeitsgang mit den Metallblechen (2, 3, 3', 20, 20') verbundenen, durch Ritzen und Brechen der Keramik entlang von Trennlinien (18', 19') in Einzelplatten getrennten Keramikplatte bestehen.

## Claims

1. Semiconductor module, consisting of a bottom panel (10), which is provided with a top side and a rear side, and at least one side panel (11, 11', 12, 12') standing approximately at a right angle to the bottom panel (10), both panels made of a ceramic material, wherein a gap (18, 19) according to the dielectric strength required is observed, as well as at least one contact plate (3, 3'), at least one conductor track plate (20, 20') and, if required, a base plate (2), the contact plate and the conductor track plate being joined by means of a metal-gas eutectic to the top side of the bottom panel (10) and to at least one of the side panels (11, 11', 12, 12', 13, 13'), and the base plate being joined by means of a metal-gas eutectic to the rear side of the bottom panel, wherein semiconductor chips (4, 4') are mounted on the contact plate (3, 3'), at least one conductor track plate (20, 20') extends in one piece from the bottom panel (10) to the side panel (11 ... 13'), and the conductor track plate (20, 20') is not joined to the ceramic material in the boundary region between two panels (10 ... 13').

2. Semiconductor module according to claim 1, characterised in that one end (25, 25') of the conductor track plate (20, 20') is not joined to the ceramic material.

3. Semiconductor module according to claim 1 or 2, characterised in that one end (25) of the conductor track plate (20) directly contacts a connection pole of a semiconductor chip (4).

4. Semiconductor module according to claim 1, 2 or 3, characterised in that an isolation mask is provided between the panel (10 ... 13') and the conductor track plate (20, 20') in the boundary region between two panels.

5. Semiconductor module according to one of claims 1 to 4, characterised in that the conductor track plate (21', 23', 25') is preformed like a bridge in the boundary region between two panels.

6. Semiconductor module according to one of claims 1 to 5, characterised in that one side panel (11 ... 13') bears an electronic driver device (30).

7. Semiconductor module according to one of claims 1 to 6, characterised in that the plates (1, 3, 3', 20, 20') consist of copper, possibly with copper(I) oxide, and the panels (10 ... 13') consist of Al₂O₃ or BeO.

8. Semiconductor module according to one of claims 1 to 7, characterised in that the bottom panel (10) and the side panel/s (11, ... 12') consist of a ceramic panel which is processed in one piece, in one operation joined to the metal plates (2, 3, 3', 20, 20') and divided into individual panels by scribing and breaking the ceramic material along dividing lines (18', 19').

## Revendications

1. Module semi-conducteur comprenant une plaque de base (10), munie d'une face supérieure et d'une face postérieure, et au moins une plaque latérale (11, 11', 12, 12') formant un angle droit avec la plaque de base (10), les deux plaques étant en céramique, respectant un entrefer (18,19) correspondant à la rigidité diélectrique exigée et comprenant au moins une plaque de contact métallique (3, 3'), au moins une bande conductrice métallique (20, 20') et, le cas échéant, une plaque de base métallique (2) -la plaque de contact métallique et la bande conductrice métallique étant reliées à l'aide d'un système eutectique métal-gaz à la face supérieure de la plaque de base (10) et au moins à l'une des plaques latérales (11, 11', 12, 12', 13, 13'), et la plaque de base métallique étant reliée à l'aide d'un système eutectique métal-gaz à la face postérieure de la plaque de base- des puces à semi-conducteurs étant fixées sur la plaque de contact métallique (3, 3'), tandis qu'au moins une bande conductrice métallique (20, 20') est posée d'un seul tenant avec la plaque de base (10) sur la plaque latérale (11 ... 13'), et que dans la zone de jonction entre deux plaques (10 ... 13'), la bande conductrice métallique (20, 20') n'est pas mise en contact avec la céramique.

2. Module semi-conducteur selon la revendication 1, caractérisé en ce qu'une extrémité (25, 25') de la bande conductrice métallique (20, 20') n'est pas mise en contact avec les plaques céramiques.

3. Module semi-conducteur selon la revendication 1 ou 2, caractérisé en ce qu'une extrémité (25) de la bande conductrice métallique (20) est directement mise en contact avec un pôle de connexion d'une puce à semi-conducteurs (4) .

4. Module semi-conducteur selon la revendication 1, 2 ou 3, caractérisé en ce que, dans la zone de jonction entre deux plaques, un masque de déconnexion est monté entre les plaques (10 ... 13') et la bande conductrice métallique (20, 20').

5. Module semi-conducteur selon l'une quelconque des revendications 1 à 4, caractérisé en ce que, dans la zone de jonction entre deux plaques, la bande conductrice métallique (21', 23', 25') est préformée en forme de pont.

6. Module semi-conducteur selon l'une quelconque des revendications 1 à 5, caractérisé en ce qu'une plaque latérale (11 ... 13') est munie d'un dispositif électronique de commande (30).

7. Module semi-conducteur selon l'une quelconque des revendications 1 à 6, caractérisé en ce que les plaques métalliques (1, 3, 3', 20, 20') sont composées de cuivre, le cas échéant d'oxyde cuivreux, et les plaques (10 ... 13') sont composées de Al₂O₃ ou BeO.

8. Module semi-conducteur selon l'une quelconque des revendications 1 à 7, caractérisé en ce que la plaque de base (10) et les plaques latérales (11,... 12') sont réalisées dans une plaque céramique d'une seule pièce, qui est assemblée au cours d'une étape de travail avec les plaques métalliques (2, 3, 3', 20, 20'), puis séparée en plusieurs plaques céramiques en entaillant et en brisant la plaque céramique le long de lignes de séparation (18', 19').
